# EUROPEAN PATENT APPLICATION

(11) **EP 2 391 044 A2**
(43) Date of publication of application: **30.11.2011**
(21) Application number: 11156938.0
(22) Date of filing: 04.03.2011
(51) Int. Cl.: H04L 1/18, H04L 1/00

(54) **A receiver for a wireless telecommunication system with a channel deinterleaver**

(30) Priority: 04.03.2010 US 717153
(71) Applicant: Designart Networks Ltd, 43657 Ra'anana (IL)
(72) Inventor: Gotman, Maxim, 44539, Kfar Saba (IL); Iron, Ran, 69400, Tel Aviv (IL); Tsadik, Meir, 45350, Hod Hasharon (IL); Toubul, Assaf, 42202, Natanya (IL)
(74) Representative: Modiano, Micaela Nadia

(57) **Abstract**

A receiver for wireless broadband telecommunication transmissions, the receiver including a demodulator for receiving transmitted modulated symbols, a channel deinterleaver memory coupled to the demodulator for receiving interleaved soft symbols and outputting deinterleaved soft symbols, an LLR calculator coupled to the channel deinterleaver memory for receiving the deinterleaved soft symbols and calculating LLRs therefore, a descrambler coupled to the LLR calculator for descrambling the LLRs, and an interleaved scrambling sequence generator coupled to the descrambler for generating an interleaved scrambling sequence and providing it to the descrambler.

## Description

### FIELD OF THE INVENTION

The present invention relates to wireless telecommunications systems, in general and, in particular, to a method and system for symbols deinterleaving and descrambling in the receiver.

### BACKGROUND OF THE INVENTION

Channel bit interleaving is a widely accepted practice in wireless communication where bits of a codeword which were initially close in time are separated in time before the actual transmission over the air. In this way, a situation is avoided where an instantaneous impairment in the wireless channel affects a continuous block of transmitted bits. Such a succession of erroneous bits makes the decoding task of most of the modern forward error correction (FEC) decoders more complicated. Instead, when the codeword is interleaved prior to transmission, such impairment is 'spread' across the whole transmitted codeword and, in the receiver, has only a local impact on a single bit each time.

At the receiver, the inverse operation of channel deinterleaving is performed on soft-bits prior to entering the FEC decoder. A 'soft bit' represents probabilistic information reflecting the likelihood of the corresponding 'hard' bit (the transmitted bit) being equal to '1' or '0', and is usually computed as the logarithm of the likelihood ratio (LLR), *In*[p(1)/p(0)]*,* where *ln* represents the natural (base e) logarithmic function, and p(1) and p(0) are the probabilities for the bit to be '1', or '0', respectively. Typically, a positive LLR value indicates more confidence that the transmitted bit was '1', and a negative LLR value indicates more confidence that the transmitted bit was '0'. When the LLR value is equal to zero, the likelihood of '0' or `1' being sent is equal. Thus, each 'soft bit' is converted to an LLR value which may be in the range of -∞and +∞. In practice, instead of infinity, the range is a fixed range. For example, an LLR value may be an integer between -128 and +127, which can be represented by 8 binary bits. In order to cope with fading channels, a higher dynamic range of LLR values is required, and thus a higher number of binary bits are required for representing each LLR value. For the purpose of deinterleaving, the LLR values of an entire transmitted block must be stored in a memory in the interleaved order, and then read from the memory in the deinterleaved order. Since the LLR values, in modern receivers, are often represented by 6 to 8 bits per originally encoded bit, the deinterleaver consumes a relatively high amount of the total available memory in the receiver.

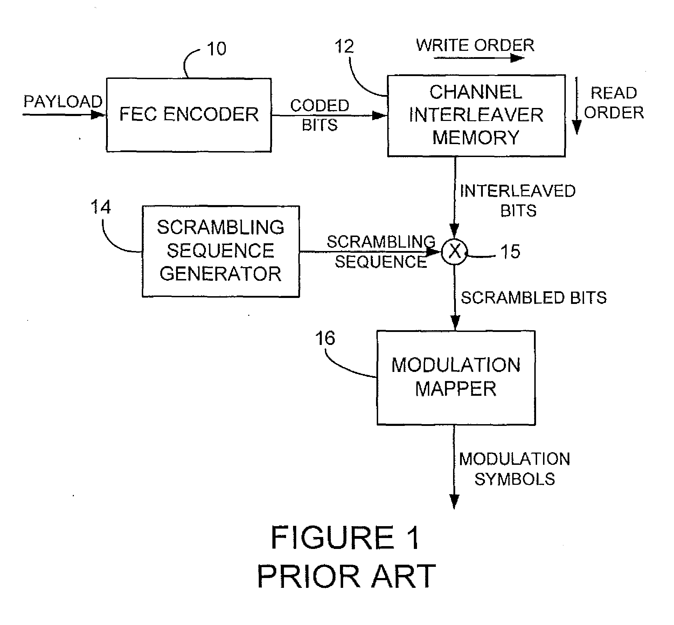

Recently, a slightly different scheme of channel interleaving was suggested, in which the interleaving process is performed on a group of bits rather than on individual bits. This group of bits is usually referred to as a symbol having a preset number of bits. This scheme is implemented in a variety of transmitters, e.g. in LTE (Long Term Evolution) Up Link transmitters. As illustrated in **Figure 1**, a block diagram illustrating a conventional transmitter implementing this scheme, a bit stream payload enters a FEC encoder **10**, which encodes the bits by adding redundant data, to allow the receiver to detect defects and errors in the transmitted message. The coded bits are stored in an interleaver memory **12**, from which they are read in the interleaved order. Since the interleaving operation in this transmitter is performed symbol-wise, in the complementary receiver, the deinterleaving is performed soft-symbol-wise.

In addition, these groups of bits undergo a bit scrambling operation with a pseudo-random bit sequence generated by a scrambling sequence generator **14**. The scrambling operation includes performing a bit-wise XOR ('exclusive or') of the data bit stream with a pseudo-random bit sequence (PRBS). After interleaving and scrambling, as in a scrambler **15**, the bits are mapped to channel symbols in a modulation mapper **16**, each group of bits to a distinct symbol. Each such symbol represents one of a preset number of possible states, and is mapped onto a carrier signal. The number of bits included in each symbol equals the log of the sum of the different possibilities in the constellation diagram of the modulation scheme. For example, a symbol in the QPSK modulation scheme includes 2 bits, since QPSK allows for 4 states. Similarly, a symbol in the 16QAM scheme includes 4 bits which is the log of the 16 possible states, a symbol in the 64QAM scheme includes 6 bits, and a symbol in the 256QAM includes 8 bits.

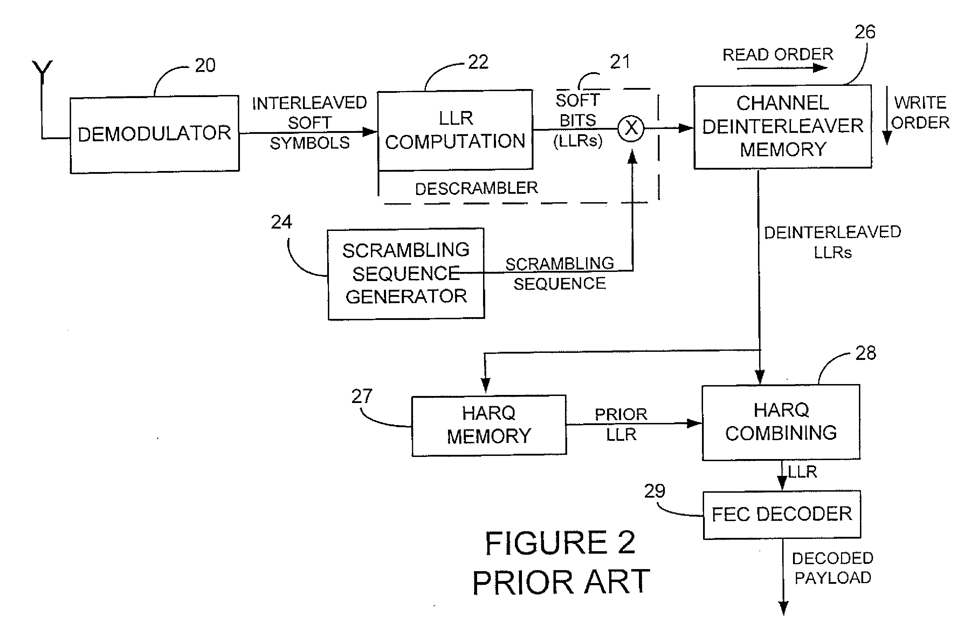

**Figure 2** is a block diagram illustration of a conventional prior art receiver, complementary to the transmitter of **Figure 1**, configured to receive modulated symbols representing an interleaved group of scrambled bits. The demodulation and decoding steps occur in the reverse order that they occur in the transmitter. Thus, a carrier signal first enters a demodulator **20** in the receiver, where soft symbols are obtained (i.e., projected onto the signal constellation plane). During the demodulation process in demodulator **20**, channel estimation is performed and, accordingly, channel correction is applied to the samples, so as to output improved samples. In addition, during channel estimation, Carrier Frequency Offset (CFO) and Sampling Timing Offset (STO) are estimated and the received samples are corrected, accordingly. The improved samples are output from the demodulator as interleaved soft symbols. These soft symbols are fed to an LLR computation unit **22.** LLR computation unit **22** converts each received soft symbol to a group of LLR values (soft bits), representing one originally encoded bit mapped to the symbol.

The LLR values are now fed to a descrambler **21**, which receives its PRBS fed from a scrambling sequence generator **24**. Scrambling sequence generator **24** generates the scrambling sequence, identical to the scrambling sequence which was applied on the originally encoded bits in the transmitter. The scrambling sequence is applied on LLR values computed by LLR computation unit **22**, resulting in a descrambled stream of LLRs.

In order to deinterleave the transmitted message, the LLRs are written in a write order into a channel deinterleaver memory **26** as one block, so they can then be read in the deinterleaving order. As stated above, although each LLR value represents one originally encoded bit only, it typically requires 6-8 bits for storing the LLR value in the memory. Thus, the deinterleaver memory typically must be very large in order to allow the LLR values of an entire data block to be stored. For example, if each LLR value is 8-bits wide, there would be needed: 4x8=32 bits to store 4 LLR values corresponding to a 16QAM symbol, 6x8=48 bits to store the 6 LLR values corresponding to a 64QAM symbol, and 8x8=64 bits to store the 8 LLR values corresponding to a 256QAM symbol.

In receivers having an HARQ combining module **28**, the deinterleaved LLR values are compared to and/or combined with the LLR values of previous transmissions. In addition, the combined LLR values of all the present transmissions, up to and including the latest retransmission, are stored in a HARQ memory **27** for use with later re-transmissions, until the codeword is properly decoded. Then, rate matching (RM) is performed in order to sort the LLRs into a stream of the expected length and in accordance with the native coding rate of the FEC decoder and to the FEC block size being used. Depending on the FEC decoder capabilities, the rate matching can, in addition to sorting the computed LLRs, either include explicitly padding the LLR stream with 'erasures', or zeros, for every un-transmitted bit of the encoded FEC block, or just informing the decoder how many computed LLR values, K, are being fed out of the overall encoded block length N, where K<=N. Finally, the LLR values are decoded by the FEC decoder **29**, which outputs the decoded payload.

It will be appreciated that deinterleaving of LLR values in high modulation schemes introduces the need for: (a) potentially large memory buffers when high modulations are in use, and (b), a relatively complicated algorithm to manage buffer allocations in order to minimize memory waste (since the required allocation depends on the modulation level). In addition, higher bandwidth of the data bus would be required, to access the deinterleaver memory during writing to and reading from it.

Accordingly, there is a long felt need for a receiver that allows demodulation and decoding of symbols without requiring large memory buffers, and it would be very desirable to have a receiver which does not require a complicated buffer allocation algorithm.

### SUMMARY OF THE INVENTION

The present invention relates to a receiver for a wireless telecommunication system and a method involving more memory efficient channel deinterleaving operations in the receiver.

There is provided, according to the present invention, a receiver for wireless broadband telecommunication transmissions, the receiver including a demodulator for receiving transmitted modulated symbols, a channel deinterleaver memory coupled to the demodulator for receiving interleaved soft symbols and outputting deinterleaved soft symbols, an LLR calculator coupled to the channel deinterleaver memory for receiving the deinterleaved soft symbols and calculating LLRs therefore, a descrambler coupled to the LLR calculator for descrambling the LLRs, and an interleaved scrambling sequence generator coupled to the descrambler for generating an interleaved scrambling sequence and providing it to the descrambler.

According to a preferred embodiment, the receiver further includes a HARQ combining and rate matching module coupled to the descrambler, a HARQ memory coupled to the HARQ combining and rate matching module, and a FEC decoder coupled to the HARQ combining module.

There is also provided, according to the invention, a method for decoding encoded and modulated transmitted signals in a receiver for wireless broadband telecommunication transmissions, the method including demodulating the received transmitted signals to interleaved soft symbols, applying channel deinterleaving on the interleaved soft symbols, calculating LLR values of the deinterleaved soft symbols and descrambling the LLR values using an interleaved scrambling sequence.

When the method is utilized with Multiple In Multiple Out (MIMO) multi-stream transmissions with horizontal encoding in the transmitter, the method further includes performing the steps of demodulating through descrambling on each MIMO stream independently.

When the method is utilized with Multiple In Multiple Out (MIMO) multi-stream transmissions with vertical encoding in the transmitter, the method further includes performing the step of deinterleaving through descrambling jointly on the combined MIMO streams. In this case, the step of descrambling includes descrambling the LLR values using a multi-stream interleaved scrambling sequence.

### BRIEF DESCRIPTION OF THE DRAWINGS

The present invention will be further understood and appreciated from the following detailed description taken in conjunction with the drawings in which:
**Figure 1** is a block diagram illustration of a prior art transmitter;
**Figure 2** is a block diagram illustration of a prior art receiver;
**Figure 3** is block diagram illustration of a receiver constructed and operative in accordance with one embodiment of the present invention; and
**Figure 4** is block diagram illustration of a combined LLR computation, descrambler and HARQ combining and rate matching module constructed and operative in accordance with one embodiment of the present invention.

### DETAILED DESCRIPTION OF THE INVENTION

The present invention relates to a method and system for wireless telecommunication providing improved deinterleaver memory utilization in the receiver. This is accomplished by applying channel deinterleaving on soft symbols (output from the demodulator) prior to descrambling the LLR values extracted from these symbols. Descrambling is carried out by applying a modified scrambling sequence on the LLR values extracted from the deinterleaved soft symbols. The modified scrambling sequence is generated by interleaving the scrambling sequence which was applied in the transmitter.

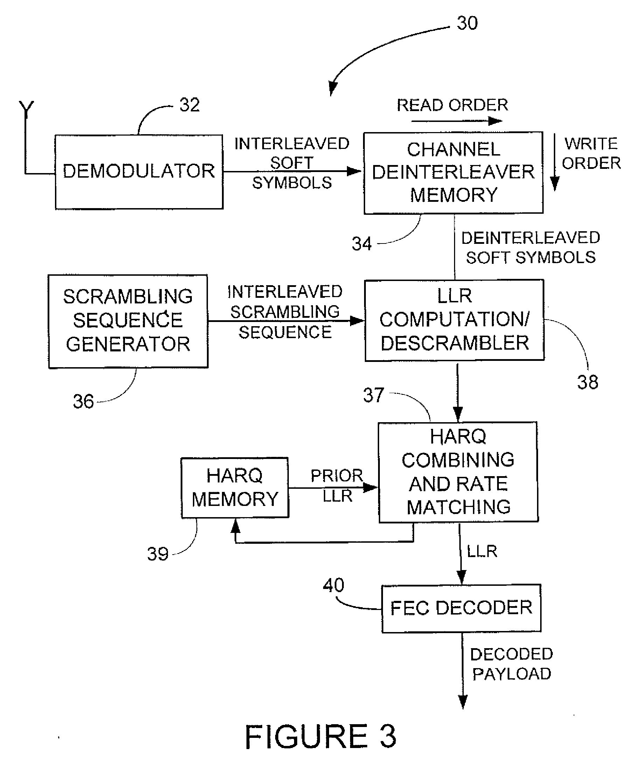

**Figure 3** is a block diagram illustrating a receiver **30** constructed and operative in accordance with one embodiment of the present invention. Receiver **30** is configured for a wireless broadband communication network, and includes a demodulator **32** coupled to a channel deinterleaver memory **34** for receiving interleaved demodulated soft symbols. Receiver 30 further includes a combined LLR computation and descrambler module **38** coupled to deinterleaver memory **34.** Module **38** implements, in hardware and/or software, an LLR computation algorithm for computing the LLR values of the deinterleaved soft symbols. An HARQ combining and rate matching (RM) module **37** is coupled to LLR computation/descrambler module **38**. It will be appreciated that only RM is performed by the module if HARQ is not used. A HARQ memory **39**, for storing computed LLR values from previous retransmissions, is coupled to HARQ combining and rate matching (RM) module **37**. In addition, combined LLR computation/descrambler module **38** is coupled to a scrambling sequence generator **36** which generates an interleaved scrambling sequence. Receiver **30** further includes a FEC decoder **40** for decoding the calculated LLR values and outputting the decoded payload.

According to one embodiment of the present invention, operation of the receiver of **Figure 3** is as follows. Symbols which are encoded and modulated onto a carrier wave, and which traveled over a wireless channel, are received in receiver 30. The modulated signal enters demodulator 32, which processes the signal to obtain interleaved soft symbols. Channel estimation and channel correction are now applied, as well as CFO and STO estimation and correction, as described above. The soft symbols are the encoded symbols which typically are distorted by residual noise due to non-perfect channel estimation and equalization, only partially cancelled interference and thermal noise, impairments of RF, etc. These encoded symbols, which were interleaved symbol-wise by the transmitter, carry information bits, which were scrambled bit-wise by the transmitter. Consequently, the LLR values extracted from the received soft symbols must be deinterleaved and descrambled by the receiver. Unlike conventional receivers, the receiver according to the present invention performs deinterleaving prior to computation of LLRs and descrambling. Accordingly, the deinterleaving is performed soft symbol-wise, i.e. the deinterleaved soft symbols are recorded into the deinterleaver memory **34** in the interleaved order (e.g., in columns), and thereafter are read from the memory in the deinterleaved order (e.g., in rows).

It will be appreciated by those skilled in the art that writing the soft symbols in the interleaving order and reading them in the deinterleaving order follows the transpose version of the rule applied in the interleaving process in the transmitter, i.e. writing column-wise then reading row-wise. Thus, the deinterleaver memory stores soft symbols (rather than LLR values), each of which is represented by a predefined number of bits regardless of the modulation level, thus saving memory space, particularly in the case of high modulation, and simplifying memory management.

In this way, significant memory savings in the channel deinterleaver memory and in the resources required for deinterleaving can be obtained. For example, if we suppose the soft symbols to be represented by a 12-bit value in each dimension, inphase and quadrature, a total of 24 bits of memory are required to store a soft symbol, regardless of its modulation level. Since, in the prior art receivers, each symbol is first converted to a set of LLR values, and each of these LLR values is typically represented by 8 bits, the deinterleaving memory must store 32 bits when each symbol includes 4 LLRs (16QAM scheme), 48 bits when each symbol includes 6 LLRs (64QAM scheme), and 64 bits when each symbol includes 8 LLRs (256QAM scheme). Thus, the present invention results in memory savings of 33% in 16QAM modulation, 100% in 64QAM modulation, and 166% in 256QAM modulation.

The deinterleaved soft symbols are input to LLR computation/descrambler module **38**, where LLR computation is performed, following which each LLR value is descrambled. After descrambling, a HARQ combining scheme is applied in HARQ combining and rate matching module **37**, and the LLR values are combined with LLRs from previous transmissions stored in HARQ memory **39**. In addition, the resultant combined set of LLRs from all retransmissions to the current one, inclusive, is stored in the HARQ memory **39**, for combining with later retransmissions, until the codeword is successfully decoded, at which time this data is flushed from the HARQ memory.

It is a particular feature of the present invention that a modified scrambling sequence is utilized for performing descrambling. The modified scrambling sequence is required since descrambling, according to the present invention, is applied to the deinterleaved stream (as opposed to descrambling an interleaved stream, as in conventional receivers). This modified scrambling sequence is generated by interleaved scrambling sequence generator **36**, which interleaves the constituent bitstream of the scrambling sequence applied in the transmitter. The interleaving process applied on the scrambling sequence follows the same rules used to deinterleave the stream of soft symbols according to the present invention (or to deinterleave the stream of LLRs in conventional receivers). Thus, the scrambling sequence, which can be stored in memory as a bit stream identical to the one used in the transmitter, is interleaved, and then applied to descramble the LLR values.

Finally, the LLR values, after rate matching, are fed to FEC decoder **40**, which processes the LLR values and outputs the decoded payload.

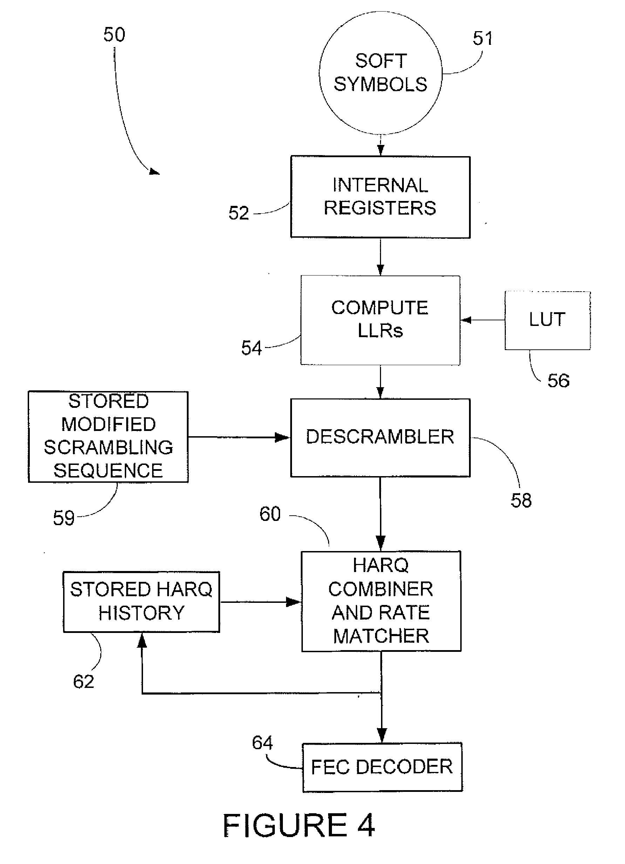

**Figure 4** is a block diagram illustrating a combined LLR computation, descrambler and HARQ combining and rate matching module **50**, constructed and operative in accordance with one embodiment of the present invention. Module **50** includes an internal register **52** for temporarily storing deinterleaved soft symbols **51.** Module **50** further includes an LLR calculator **54** coupled to internal register **52** and configured to compute the LLR values from each soft symbol in the internal register. Computing the LLR values is, preferably, carried out by utilizing a look up table **56**. In addition, module **50** includes a descrambler **58,** coupled to the LLR calculator **54**. Descrambler **58** applies a modified scrambling sequence on each bit of the LLR values. According to one embodiment, the modified scrambling sequence is stored in a memory device **59**, which is integrated in module **50**. Alternatively, memory device **59** may be an independent device coupled to descrambler **58.** Preferably, a HARQ combiner and rate matching module **60**, having an associated HARQ memory **62**, is coupled to descrambler **58**, for combining the computed and descrambled LLRs with LLRs from previous transmissions, as described above. HARQ combining and rate matching module **60** is further coupled to a FEC decoder **64**.

It will be appreciated that many broadband transmissions at present utilize MIMO (Multiple In Multiple Out) techniques, where data is transmitted simultaneously over several streams. When MIMO is utilized and interleaving is performed, two options are available: horizontal encoding, where each stream is interleaved independently, and vertical encoding, where the combined streams are interleaved. When multiple user MIMO, and sometimes single user MIMO, with horizontal encoding is utilized in the transmitter, the above-described process is implemented on each MIMO stream. In other words, each stream is interleaved with itself, independently per stream or layer and deinterleaved independently, as described. In other cases of single user MIMO, vertical encoding with interleaving is applied on data streams in the encoder. In this case, the deinterleaving described above is performed jointly for the combined streams. It will be appreciated that, in this case, the sequence generator will provide a multi-stream interleaved scrambled sequence, not a single stream interleaved sequence. Thus, interleaving can be performed not only in the time frame but also in streams or layers.

While the invention has been described with respect to a limited number of embodiments, it will be appreciated that many variations, modifications and other applications of the invention may be made. It will further be appreciated that the invention is not limited to what has been described hereinabove merely by way of example. Rather, the invention is limited solely by the claims which follow.

## Claims

1. A receiver for wireless broadband telecommunication transmissions, the receiver comprising:
a channel deinterleaver memory for receiving interleaved soft symbols and outputting deinterleaved soft symbols;
an LLR computation module coupled to said channel deinterleaver memory for receiving said deinterleaved soft symbols and calculating LLRs therefor;
a descrambler coupled to said LLR computation module, said descrambler utilizing an interleaved scrambling sequence for descrambling said LLRs.

2. The receiver according to claim 1, further comprising:
a HARQ combining and rate matching module coupled to said descrambler;
a HARQ memory coupled to said HARQ combining and rate matching module; and
a FEC decoder coupled to said HARQ combining and rate matching module.

3. The receiver according to claim 1, further comprising an interleaved scrambling sequence generator coupled to said descrambler for generating said interleaved scrambling sequence and providing it to said descrambler.

4. The receiver according to claim 2, further comprising an interleaved scrambling sequence generator coupled to said descrambler for generating said interleaved scrambling sequence and providing it to said descrambler.

5. The receiver according to any of the preceding claims, further comprising a demodulator for performing channel estimation and correction, Carrier Frequency Offset (CFO) and Sampling Timing Offset (STO) estimation and correction, and for outputting said interleaved soft symbols.

6. A method for decoding received encoded transmitted signals in a receiver for wireless broadband telecommunication transmissions, the method comprising:
applying channel deinterleaving on interleaved soft symbols representing the transmitted signals;
calculating LLR values of said deinterleaved soft symbols; and
descrambling said LLR values using an interleaved scrambling sequence.

7. The method according to claim 6, further comprising demodulating the received transmitted signals by performing channel estimation and correction, Carrier Frequency Offset (CFO) and Sampling Timing Offset (STO) estimation and correction, and to generate said interleaved soft symbols.

8. The method according to claim 6 or claim 7, where the transmitted signals include Multiple In Multiple Out (MIMO) multi-stream transmissions with horizontal encoding in the transmitter, the method further comprising:
performing said steps of applying through descrambling on each MIMO stream independently.

9. The method according to claim 6 or claim 7, where the transmitted signals include Multiple In Multiple Out (MIMO) multi-stream transmissions with vertical encoding in the transmitter,
the method further comprising performing said step of deinterleaving through descrambling jointly on the combined MIMO streams; and
wherein said step of descrambling includes descrambling said LLR values using a multi-stream interleaved scrambling sequence.

10. The method according to claim 6, wherein:
Said step of applying includes:
storing demodulated interleaved soft symbols in a channel deinterleaver memory in a received order; and
reading said soft symbols in a deinterleaved order;
and said step of descrambling includes:
generating an interleaved scrambling sequence; and
descrambling said LLRs by applying said interleaved scrambling sequence to said LLRs;
further comprising decoding said descrambled LLRs in a FEC decoder.

11. The method according to claim 10, further comprising:
coupling a HARQ memory to said descrambler; and
performing HARQ combining, using LLRs, stored in said HARQ memory, of previous transmissions of the transmitted signals, on said descrambled LLRs, and
performing rate matching on said post-combining LLRs, before said step of decoding.
